Europäisches Patentamt

European Patent Office

Office européen des brevets

(19)

(11) Veröffentlichungsnummer: **0 308 680**
A1

# (12) EUROPÄISCHE PATENTANMELDUNG

(21) Anmeldenummer: 88113900.0

(22) Anmeldetag: 26.08.88

(51) Int. Cl.4: **C23C 14/34**

(30) Priorität: 21.09.87 DE 3731693
12.02.88 US 155206
20.05.88 US 197040

(43) Veröffentlichungstag der Anmeldung:
29.03.89 Patentblatt 89/13

(84) Benannte Vertragsstaaten:
DE FR GB IT LU NL SE

(71) Anmelder: **LEYBOLD AKTIENGESELLSCHAFT**
**Wilhelm-Rohn-Strasse 25**
**D-6450 Hanau 1(DE)**

(72) Erfinder: **Campbell, Gregor A.**
**222 W.Orange Grove Avenue**
**Burbank CA 91502(US)**
Erfinder: **Conn, Robert W.**
**222 W. Orange Grove Avenue**
**Burbank CA 91502(US)**
Erfinder: **Goebel, Daniel M.**
**222 W. Orange Grove Avenue**
**Burbank CA 91502(US)**
Erfinder: **Adam, Rolf**
**Wilhelmstrasse 7**
**D-6450 Hanau 1(DE)**
Erfinder: **Aichert, Hans Dr.**
**Westbahnhofstrasse 15**
**D-6450 Hanau 1(DE)**
Erfinder: **Betz, Hans Dr.**
**Rhoenstrasse 1**
**D-6454 Bruchköbel(DE)**
Erfinder: **Dietrich, Anton Dr.**
**Heilbrunn 16**
**D-8441 Wiesenfeld(DE)**
Erfinder: **Dittmer, Gonde Dr.**
**Finkenweg 16**
**D-5093 Burscheid(DE)**
Erfinder: **Hartig, Klaus Dr.**
**Hanauer Strasse 17 D-6451 Ronneburg 2**
**De(DE)**
Erfinder: **Hass, Friedrich**
**Jahnstrasse 11**
**D-6458 Rodenbach(DE)**
Erfinder: **Ludwig, Rainer Dr.**
**Uhlandstrasse 3**
**D-8757 Karlstein-Bettingen(DE)**
Erfinder: **Mayr, Max Dr.**
**Vogelsbergstrasse 12a**
**D-8755 Alzenau-Wasserlos(DE)**

EP 0 308 680 A1

Erfinder: **Thelen, Alfred Dr.**
**Limesstrasse 24**
**D-6393 Wehrheim/Ts(DE)**

(54) **Vorrichtung zum Kathodenzerstäuben.**

(57) Bei einer Vorrichtung zum Aufbringen von Werkstoffen auf ein in einer Vakuumkammer (16, 17) angeordnetes Substrat (15), mit einem Elektronen-Emitter (9), der in einer separaten, mit der Vakuumkammer (16, 17) korrespondierenden, die Anode (11) bildenden Generatorkammer (37) angeordnet ist und der nach dem Einleiten eines Prozeßgases in die Generatorkammer (37) eine großflächige Plasmasäule (S) erzeugt, die unter der Einwirkung von Magneten (64, 30, 21, 21′ 44) zwischen Elektronen-Emitter (9) und einer Targetanordnung (7) geführt ist, sind die positiven Ionen durch Anlegen einer einstellbaren negativen Spannung auf das Target (7) beschleunigbar, von wo aus die abgestäubten Metallatome auf das Substrat (15) gelangen. Die Targetanordnung (7) ist dazu in unmittelbarer Nachbarschaft des dem Elektronen-Emitter (9) gegenüberliegenden Endes des die Prozeßkammer (37) verlängernden Rohrstutzens (19) angeordnet, wobei ein dem Substrat (15) benachbarter Magnet (106) eine Teilung und Umlenkung des abgeteilten Plasmafadens ( S2) bewirkt.

FIG.1

## Vorrichtung zur Kathoden-Zerstäubung

Die Erfindung betrifft eine Vorrichtung zur Kathoden-Zerstäubung.

Es ist ein Verfahren zum Herstellen transparenter Wärmespiegel durch Ablagerung eines Films aus versetztem Indiumoxid oder versetztem Zinnoxid auf ein Substrat bekannt (EU-PS 0 020 456), bei dem als Ablagerung eine Niedrigtemperatur-Ablagerung auf ein Polymersubstrat durch Zerstäubung, thermische Verdampfung, Vakuumaufdampfung oder Elektronenbeschuß verwendet wird, wobei während der Ablagerung ein Sauerstoff-Partialdruck in einem Bereich benutzt wird, der unmittelbar Filme des genannten Materials mit einer hohen Transparenz und einem hohen Reflexionsvermögen erzeugt.

Bei der verwendeten Vorrichtung zur Durchführung des Verfahrens ist ein wassergekühltes Target in einem Winkel von etwa 45° gegenüber dem von einer Strahlquelle erzeugten Ionenstrahl in der mit einem Gaseinlaß versehenen Vakuumkammer angeordnet, wobei das ausgeworfene Targetquellenmaterial ein Beschichten des winklig zum Target angeordneten, mit einem Polymer beschichteten Substrats bewirkt.

Weiterhin ist ein Plasmagenerator mit Ionenstrahlerzeuger bekannt (Aufsatz von D. M. Goebel, G. Campbell und R. W. Conn im Journal of Nuclear Material 121 (1984) 277 - 282, North Holland Physics Publishing Division, Amsterdam), der in einer mit der Vakuumkammer verbundenen, separaten Kammer angeordnet ist, wobei die etwa zylindrische Kammerwand dieser separaten Kammer die Anode bildet und mit einem Einlaßstutzen für das Prozeßgas versehen ist. Die zylindrische Kammer ist von ringförmigen Magnetspulen und mit Rohren zur Kühlung der Kammerwand versehen. Der Elektronen-Emitter selbst befindet sich an einem das eine Ende der zylindrischen Kammer verschließenden, dem eigentlichen Vakuumkessel abgekehrten Wandteil.

Weiterhin ist eine Kathoden-Zerstäubungsvorrichtung mit hoher Zerstäubungsrate bekannt (US 2,417,288) mit einer Kathode, die auf einer ihrer Oberflächen das zu zerstäubende und auf einem Substrat abzulagernde Material aufweist, mit einer derart angeordneten Magneteinrichtung, daß von der Zerstäubungsfläche ausgehende und zu ihr zurückkehrende Magnetfeldlinien einen Entladungsbereich bilden, der die Form einer in sich geschlossenen Schleife hat und mit einer außerhalb der Bahnen des zerstäubten und sich von der Zerstäubungsfläche zum Substrat bewegenden Material angeordneten Anode, wobei die zu zerstäubende und dem zu besprühenden Substrat zugewandte Kathodenoberfläche eben ist und wobei die das Magnetfeld erzeugende Magneteinrichtung auf der der ebenen Zerstäubungsfläche abgewandten Seite der Kathode angeordnet ist.

Der vorliegenden Erfindung liegt die Aufgabe zugrunde, eine Vorrichtung zum Hochraten-Zerstäuben und/oder zum Verdampfen metallischer oder dielektrischer Werkstoffe mit Hilfe eines fremderzeugten Plasmas zu schaffen, bei der die der Targetanordnung zuführbare Leistung besonders groß ist, deren Aufbau einfach ist, in welcher die Plasmaerzeugung unabhängig von der Targetanordnung erfolgt und bei der die Targetspannung und der Targetstrom voneinander unabhängig einstellbar sind. Außerdem soll ein Umschalten von konventioneller, magnetfeldunterstützter Kathoden-Zerstäubung auf eine Kathoden-Zerstäubung mit von außen zugeführtem Plasma möglich sein. Schließlich soll die nutzbare Targetdicke möglichst groß und ihre Abnutzung möglichst gleichmäßig sein.

Erfindungsgemäß wird diese Aufgabe dadurch gelöst, daß die Vakuumkammer mit einer Einrichtung zur Erzeugung eines Plasmastrahls verbunden ist und ein Target aufweist, das mit Magneten zusammenwirkt, die den Plasmastrahl auf die Oberfläche des Targets lenken und mit einer Einrichtung versehen ist, um Ionen im Plasmastrahl zu beschleunigen, die die Oberfläche des Targets treffen und Teilchen herauslösen und das mit Substrathaltern versehen ist, die im Inneren der Vakuumkammer zur Halterung der Substrate für die Beschichtung mit abgestäubten Teilchen angeordnet sind und das schließlich mit einer Einrichtung, für die Ablenkung eines Teils des Plasmastrahls auf das Substrat ausgestattet ist.

Zweckmäßigerweise weist der Plasmastrahl-Generator einen Elektronen-Emitter mit einer nachgeschalteten rohrförmigen Anode und einen Einlaß für das Prozeßgas zum Zünden des Plasmastrahls und einen Rohrstutzten auf, der sowohl mit der Anode als auch mit der Vakuumkammer zusammenwirkt und außerdem Magnete zum Ausrichten und Führen des Plasmastrahls durch die Anode in die Prozeßkammer.

Eine bevorzugte Ausführungsform ist gekennzeichnet durch eine Plasmaquelle, durch ein Target, das dem Plasmastrahl in der Vakuumkammer ausgesetzt ist, durch einen Magneten, der den Plasmastrahl auf die Oberfläche des Targets lenkt, durch eine Spannungsquelle, die Ionen im Plasmastrahl auf die Ob erfläche des Targets beschleunigt und dort Teilchen abstäubt und durch einen käfigartigen Substrathalter an der Vorderseite des Targets, wobei dieser den Plasmastrahl umschließt und das Substrat für die Beschichtung hält.

Die Vorrichtung kann alternativ auch so ausgebildet sein, daß sie eine mit der Vakuumkammer verbundene Einrichtung zur Erzeugung eines Plasmastrahls aufweist und ein in der Vakuumkammer angeordnetes Target mit einem Magneten, der den Plasmastrahl auf die Oberfläche des Targets lenkt, und eine Einrichtung zur Beschleunigung von Ionen im Plasmastrahl auf die Oberfläche des Targets, um auf dieser Teilchen abzustäuben und einen Substrathalter, der in der Vakuumkammer angeordnet ist und ein Substrat hält, damit dieses mit abgestäubten Teilchen beschichtbar ist, wobei aber das Target außerhalb des Pfads des Plasmastroms angeordnet ist.

Mit Vorteil findet ein Verfahren Anwendung, für das eine Vakuumkammer mit einem Plasmastrahl-Generator verbunden ist, der auf das Innere der Vakuumkammer einwirkt, bei dem ein Target und ein Substrathalter in der Vakuumkammer vorgesehen sind, bei dem der Substrathalter das Substrat zum Zwecke seiner Beschichtung hält, bei dem eine magnetische Einrichtung den Plasmastrahl auf die Oberfläche des Targets lenkt, wobei Ionen im Plasmastrahl beschleunigt werden, die die Oberfläche des Targets treffen und von diesem Teilchen abstäuben und bei dem ein Teil des Plasmastrahls abgeteilt und auf das Substrat gelenkt wird.

Weitere Einzelheiten und Merkmale der Erfindung sind in den Unteransprüchen gekennzeichnet:

Die Erfindung läßt die verschiedensten Ausführungsmöglichkeiten zu; einige davon sind in den anhängenden Zeichnungen schematisch näher wiedergegeben, und zwar zeigen:

Fig. 1 eine Vorrichtung mit einer separaten Plasmaquelle zur Beschichtung von Bändern und Folien mit einem schräg zum Plasmastrahl gehaltenen Target, im Längsschnitt und rein schematisch dargestellt,

Fig. 2 eine Vorrichtung der in Fig. 1 dargestellten Art, jedoch mit einem quer zum Plasmastrahl verschiebbar gehaltenen Target und mit einem auf dessen Rückseite angeordneten Magneten,

Fig. 2A die Teildarstellung der Vakuumkammer und der Verlauf des Plasmastrahls bei einer Ausführungsform ähnlich derjenigen nach Fig. 2, wobei insbesondere die Magnetfeldlinien zwischen der Magnetspule am Rohrstutzten und dem schräg gestellten und nach unten verschobenen Target angedeutet sind,

Fig. 2B die Teildarstellung der Vakuumkammer und der Verlauf des Plasmastrahls bei horizontal gestelltem Target der Ausführungsform nach Fig. 2,

Fig. 3 eine Vorrichtung der in Fig. 1 dargestellten Art, jedoch mit einem an der Generatorkammer unmittelbar angeordneten kreisringförmigen Target,

Fig. 4 eine Vorrichtung des in Fig. 3 dargestellten Typs, jedoch mit zusätzlichem Reaktivgaseinlaß im Bereich zwischen Target und Substrat und mit zusätzlicher Absaugung aus einer von Blenden begrenzten Kammer,

Fig. 4A die Teildarstellung der Target- bzw. Substratanordnung mit dem Verlauf der Magnetfeldlinien am ringförmigen Target der Vorrichtung nach Fig. 4,

Fig. 5 eine Vorrichtung des in Fig. 3 dargestellten Typs, jedoch mit einem wannen- bzw. trichterförmig ausgeformten Target,

Fig. 6 eine Vorrichtung mit zusätzlichen Permanentmagneten im Bereich von zwei winklig zueinander angeordneten Targets,

Fig. 7 die perspektivische Darstellung eines mehrteiligen, ringförmigen Targets

Fig. 8 den Längsschnitt durch die in Fig. 6 dargestellten Targets, jedoch in vergrößertem Maßstab,

Fig. 9 die perspektivische Darstellung der Targets und der Prozeßkammer mit rechteckigem Querschnitt nach den Figuren 6 und 8 und

Fig. 10 eine Vorrichtung des in Fig. 1 dargestellten Typs, jedoch für die Beschichtung von Draht eingerichtet und mit einem quer zum Plasmastrahl angeordneten plattenförmigen, mehrteiligen Target und mit kranzförmig angeordneten Düsen für den Gaseinlaß.

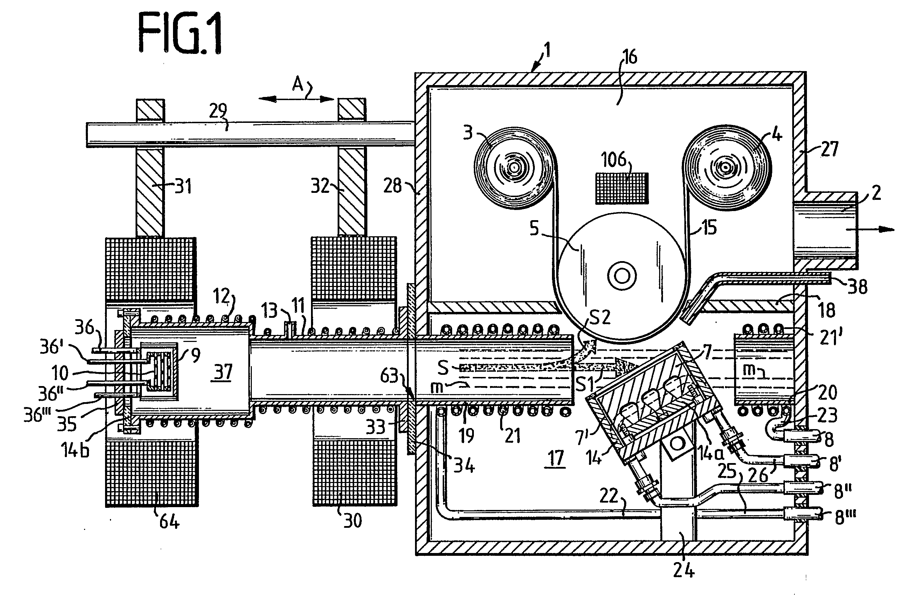

Die Beschichtungsvorrichtung nach Fig. 1 besteht im wesentlichen aus einem Vakuumkessel 1 mit Pumpöffnung 2, dem im Vakuumkessel 1 drehbar gelagerten Abwickler 3 und Aufwickler 4, der ebenfalls drehbar gelagerten Beschichtungswalze 5, der den Vakuumkessel 1 in zwei Kammern 16, 17 teilenden Trennwand 18, dem sich parallel zur Trennwand 18 quer im Vakuumkessel 1 erstreckenden Rohrstutzen 19 mit dem auf ihn aufgewickelten, eine Magnetspule 21 und eine Kühlschlange bildenden Rohr 22, einem auf einem Lagerbock 24 in schräger Lage zu der Trennwand 18 und dem Rohrstutzen 19 gehaltenen Target 7 mit Isolator 14, 14A, den beiden, den elektrischen Strom und das Kühlwasser leitenden Schlauchleitungen 25, 26, die ebenso wie das Rohr 22 durch die eine Stirnwand 27 des Vakuumkessels 1 bei 8´, 8´´, 8´´´ abgedichtet hindurchgeführt sind und der Magnetspule 106 auf der Rückseite der Beschichtungswalze 5 bzw. dem folienartigen Substrat 15.

Weiterhin weist die Beschichtungsvorrichtung eine an der anderen Stirnwand 28 des Vakuumkessels 1 fest angeordnete Schiene 29 auf, auf der die Magnetspulen 64, 30 mit ihren Spulenhalterungen 31, 32 in Pfeilrichtung A verschiebbar geführt sind, wobei konzentrisch zu den Magnetspulen 64, 30 die als Hohlprofil ausgebildete Anode 11 vorgesehen ist, deren Längsachse mit der Längsachse des Rohrstutzens 19 fluchtet und deren der Kammer 17 des Vakuumkessels 1 abgekehrtes Ende mit einem Isolator 14B verschlossen ist, der einen Elektronen-Emitter 9 mit Heizung 10 trägt.

Die Anode 11 weist an ihrem dem Vakuumkessel 1 zugekehrten Ende einen Flansch 33 auf, mit dem sie an der Stirnwand 28 des Vakuumkessels 1 gehalten ist, wobei jedoch zwischen dem Flansch 33 und der Stirnwand 28 ein Isolator 34 angeordnet ist, der die rohrförmige Anode 11 elektrisch vom Rohrstutzen 19 bzw. der Stirnwand 28 isoliert. Die als Hohlprofil ausgebildete Anode 11 weist seitlich einen sich radial nach außen zu erstreckenden Einlaßstutzen 13 auf und ist von einer Rohrschlange 12 umschlossen, die von Kühlwasser durchflossen ist. Der Isolator 14B ist fest mit einer Lochplatte 35 verbunden, an der die Wasser- und Stromdurchführungen 36, 36', ... vorgesehen sind.

Im Innern der rohrförmig ausgebildeten, evakuierten Generatorkammer 37 werden aus dem Elektronen-Emitter 9 (der beispielsweise aus Lanthanhexaborid gebildet ist) großflächig Elektronen emittiert und zu der Anode 11 beschleunigt. Durch gleichzeitig in die Generatorkammer 37 über den Stutzen 13 eingelassenes Gas wird ein Plasma in der Generatorkammer 37 gezündet.

Durch die Magnetspulen 30, 21, 21', 64, 106, welche sowohl die Generatorkammer 37 als auch den Rohrstutzen 19, das an der Stirnwand 27, befestigte Rohrstück 20, das Target 7 und den Substrathalter 5 umgeben bzw. an diesen Teilen gehalten oder hinter diesen Teilen befestigt sind, wird das Plasma auf einen schlauchförmigen Bereich zwischen Elektronen-Emitter 9 der Generatorkammer 37 und dem Target 7 bzw. dem Substrat 15 begrenzt. Die Magnetfelder bewirken dabei, daß die emittierten Primärelektronen den Feldlinien entlang driften und nur über Stöße zur Anoden 11 gelangen können, wobei aus dem Target 7 geschlagene Sekundärelektronen, die ebenfalls zur Ionisierung beitragen, eingefangen werden. Die dabei erzeugten Ionen driften ebenfalls entlang der Magnetfeldlinien. Am Target 7 steht so ein Ionenstrom von hoher Intesität (bis in die Größenordnung A/cm²) zur Verfügung. Die Energie der Ionen ist jedoch vergleichsweise gering.

Wird nun am Target 7 ein negatives Potential angelegt, so werden die Ionen aus der Plasmarandschicht auf das Target 7 beschleunigt.

Durch Änderung des Magnetfeldes ist es möglich, den Plasmastrahl S2 um bis zu 180° zu "biegen", weshalb die Einbaulage des Targets 7 relativ zur Längsachse 2 der Generatorkammer 37 oder des Plasmastroms S bzw. zu den Rohrstutzen 19, 20 nahezu beliebig wählbar ist.

Bei der metallischen Kathodenzerstäubung wird in die Generatorkammer 37 Argongas über den Stutzen 13 eingelassen, ein Argonplasma gezündet und an das Target 7 eine Spannung im Bereich 100 V bis kV angelegt. Es herrschen auf der Targetoberfläche Bedingungen, ähnlich der DC-Kathodenzerstäubung, wobei sich vergleichbare Eigenschaften der aufgestäubten Schichten ergeben. Gegenüber der DC-Kathodenzerstäubung sind jedoch folgende Vorteile feststellbar:

Die dem Target 7 zugeführte Leistung ist bedeutend größer. So ergibt sich z.B. mit dem Ionenstrom von 1 A/cm² und einer Targetspannung von 750 V eine Flächenleistung auf dem Target von 750 W/cm². Dies ist zu vergleichen mit einer maximalen Flächenleistung bei der DC-Magnetron-Kathodenzerstäubung von einigen zehn W/cm². Entsprechend erhöht sich die Aufstäubrate. Gemessen wurde für Kupfer eine Rate von 1200 A/s bei einem Substratabstand von 100 mm und einem Plasmastrahldurchmesser von ebenfalls 100 mm.

Targetstrom und Targetspannung sind unabhängig voneinander einstellbar, wohingegen bei der DC-Kathodenzerstäubung beide Größen über eine Kennlinie verknüpft sind. Die Möglichkeit der unabhängigen Einstellbarkeit von Strom und Spannung bietet den Vorteil, die Zerstäubungsrate über dem Targetstrom und die Eigenschaft der aufgestäubten Schicht über die Targetspannung unabhängig voneinander beeinflussen zu können.

Wird bei einer reaktiven Kathodenzerstäubung in der Nähe des Substrats 15 über den Einlaßstutzen 38 Reaktivgas in die Kammer 17 eingelassen, so sind die physikalischen Bedingungen denen der konventionellen reaktiven Kathodenzerstäubung vergleichbar. Als Reaktivgas eigenet sich insbesondere oxygen, nitrogen, ammonia oder acetylene.

Ein wesentlicher Unterschied zu herkömmlichen Vorrichtungen besteht darin, daß die die Ionisation auslösenden Elektronen beim reaktiven Kathodenzerstäuben vom Target 7 geliefert werden und der Prozeß daher sehr empfindlich auf Änderungen der chemischen Beschaffenheit der Targetoberfläche reagiert. Bei der hier beschriebenen Vorrichtung werden die Ionen von außen zugeführt und das System verhält sich wesentlich stabiler.

Die zum metallischen Kathodenzerstäuben genannten Vorteile kommen hier voll zum Tragen. Ein zusätzlicher Vorteil ist darin zu sehen, daß der intensive Plasmastrahl dazu genutzt werden kann, das eingelassene Reaktivgas reaktiver zu machen (Dissozieren von Reaktivgas-Atomen). Die beim reaktiven Zerstäubungsprozeß in der Regel notwendigen zusätzlichen Blendensysteme, Anoden und Anodenstromversorgungen entfallen hier.

Bei einem Versuch wurden mit dem beschriebenen System Aluminiumnitritschichten mit einer Rate von ca. 100 A/s aufgebracht. Diese Rate ist etwa einen Faktor 3 höher als beim reaktiven DC-Magnetronzerstäuben.

Bei genügender Abschwächung des magnetischen Feldes hinter dem Target 7 ist es möglich, den Plasmastrahl in zwei Teilstrahlen aufzuteilen, von denen einer zur Zerstäubung des Metalltargets 7 und der zweite zur Aktivierung des Reaktivgases bzw. zur Plasmabehandlung des Substrats 15 genutzt werden kann. In diesem Fall ist durch geeignete Druckstufen die Elektronentemperatur in beiden Teilstrahlen unabhängig beeinflußbar.

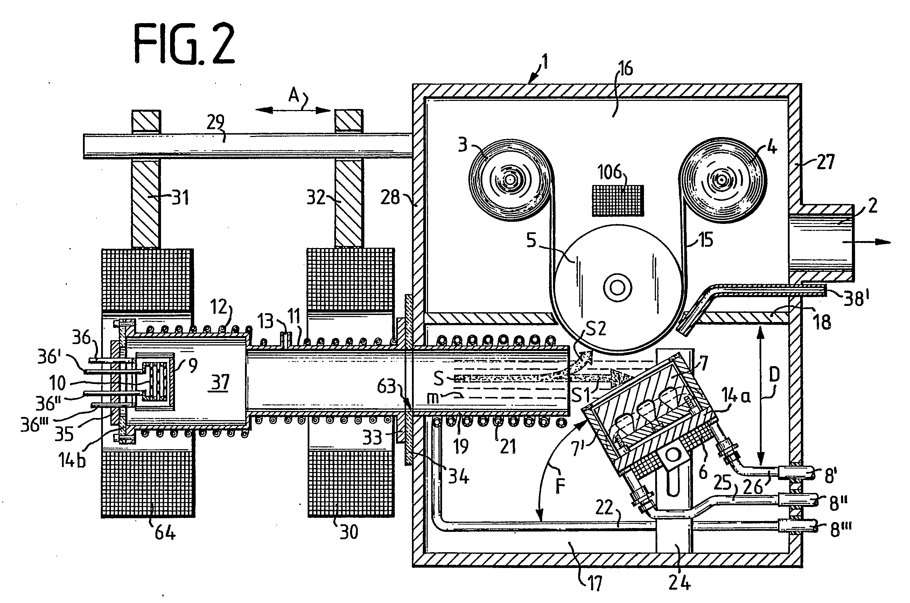

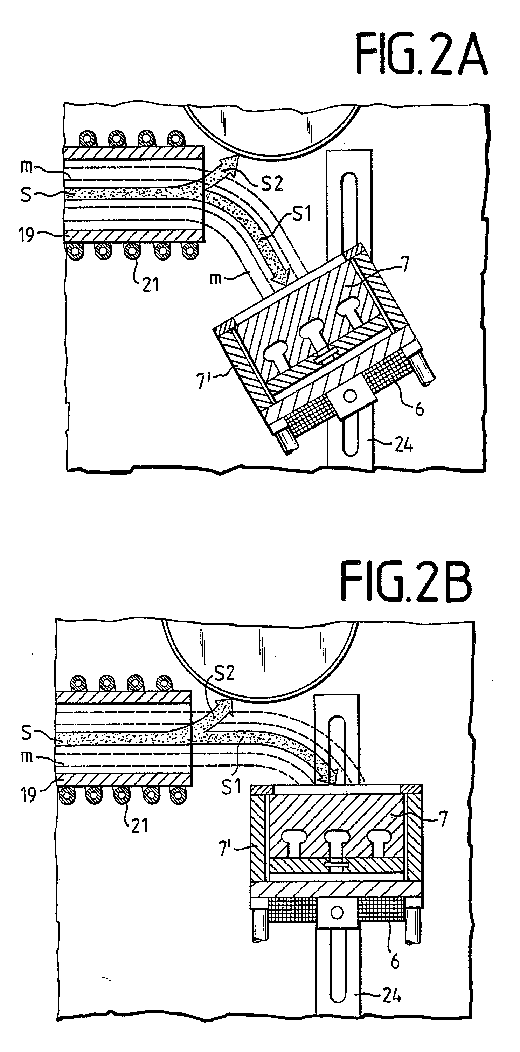

Bei den erreichbaren hohen Energiedichten ist es auch möglich, bei genügend geringer Kühlung des Targets 7 ein geeignetes Target durch den Plasmastrahl zu schmelzen und zu verdampfen. In diesem Fall ist das Target 7 waagrecht, d.h. parallel zur Längsachse des Rohrstutzens 19 anzuordnen wie dies in Figur 2 B dargestellt ist.

Durch das vorhandene intensive Plasma entstehen Schichten mit gegenüber den gängigen Verdampfereinrichtungen verbesserten Eigenschaften, da im Plasma abgedampfte Metall-Cluster aufgebrochen und die abgedampften Metallatome zum Teil ionisiert werden.

Von der Maschinenseite her bietet die beschriebene Vorrichtung Vereinfachungen, da im Gegensatz zum Ionen- bzw. Elektronenstrahl-Verdampfen keine Hochspannung erforderlich ist (Typische Quellenspannung 80 V, Typische Targetspannung 700 V).

Der Plasmastrahl kann großflächig in beliebiger Form hergestellt werden. Eine Scan-Vorrichtung ist nicht erforderlich. Dadurch, daß der Plasmastrahl von sich aus quasi neutral ist, vereinafcht sich die Handhabung erheblich. Zusätzliche Einrichtungen zur Neutralisierung des Strahls sind nicht notwendig.

Zur Beschichtung eines Substrats 15 mit einer Legierung bestimmter Zusammensetzung ist es möglich, ein entsprechendes Target 7 zu benutzen und eine Kathodenzerstäubung zu betreiben.

Soll jedoch die Zusammensetzung der aufzubringenden Schicht geändert werden können, so ist es sinnvoll, verschiedene Targets 7, bestehend aus den einzelnen Legierungsbestandteilen zu verwenden und mit einem großflächigen Plasmastrahl sämtlich Targes zu überdecken. Durch Anlegen unterschiedlich hoher elektrischer Spannungen an den einzelnen Targetsorten läßt sich die gewünschte Zusammensetzung der auf das Substrat 15 aufgestäubten Schicht einstellen.

Durch die geringe Baugröße des hier verwendeten Targets 7 ist es möglich, zum Beispiel Targetteile aus zwei verschiedenen Materialien schachbrettartig anzuordnen und da Aufstäuben einer Legierung auf ein Substrat 15 mit geringen Schwankungen der Zusammensetzung über die Beschichtungsbreite zu erreichen.

Weiterhin ist es möglich, mehrere Targets 7 konzentrisch zur Plasmastrahlachse S bzw. senkrecht zu den Magnetfeldlinien m anzuordnen. Da jedem Target 7 eine zur Strahlachse symmetrische Aufstäubungsrte zuzuordnen ist, ergibt sich auf einem Substrat paralell zum Plasmastrahl S eine über die gesamte Beschichtungsfläche konstante Zusammensetzung der verschiedenen aufgestäubten Schichtbestandteile.

Bei geeigneter Wahl der Betriebspartner ist es weiterhin möglich, die beschriebene Vorrichtung als Metall-Ionenquelle zu betreiben.

Die Ionisationswahrscheinlichkeit der abgestäubten Metallatome im Plasmastrahl ist unter anderem eine Funktion von Plasmadichte und Elektronentemperatur.

Bei den hier üblichen Plasmadichten läßt sich durch Absenkung des Neutralteildruckes auf $3 \times 10^{-4}$ mbar die Elektronentemperatur soweit erhöhen, daß zum Beispiel Cu-Atome schon innerhalb von wenigen cm-Weglänge durch das Plasma ionisiert werden.

Steht nun das Target 7 senkrecht zu den Magnetfeldlinien, so ergeben sich aufgrund der unterschiedlichen Massen und Energien der verschiedenen Ionensorten unterschiedliche Lamorradien, mit denen die einzelnen Ionensorten um die Magnetfeldlinien kreisen (z.B. Ar = 4 cm; Cu = ca. 14 cm, bei einer Magnetstärke von 100 Gauß). Dadurch ist es möglich, die Metall-Ionensorten zu separieren.

Es bleibt zu Figur 1 noch zu erwähnen, daß ein die Stirnwand 27 und die Trennwand 18 durchdringender Rohrstutzen 38 vorgesehen ist, über den Gas in den Bereich zwischen dem Target 7 und dem Substrat 15 eingeleitet werden kann. Während bei der Ausführungform nach Figur 2 das Target 7 als fest am Lagerbock 24 in schräger Lage gehalten ist, bietet die Ausführungsform nach Figur 2 die Möglichkeit, das Target 7 am Lagerbock in vertikaler Richtung zu verschieben, wie das in Figur 2A dargestellt ist, darüberhinaus ist bei dieser Vorrichtung nach den Figuren 2, 2A, 2B das Target 7 mit einem Magneten 6 auf seiner Rückseite ausgestattet.

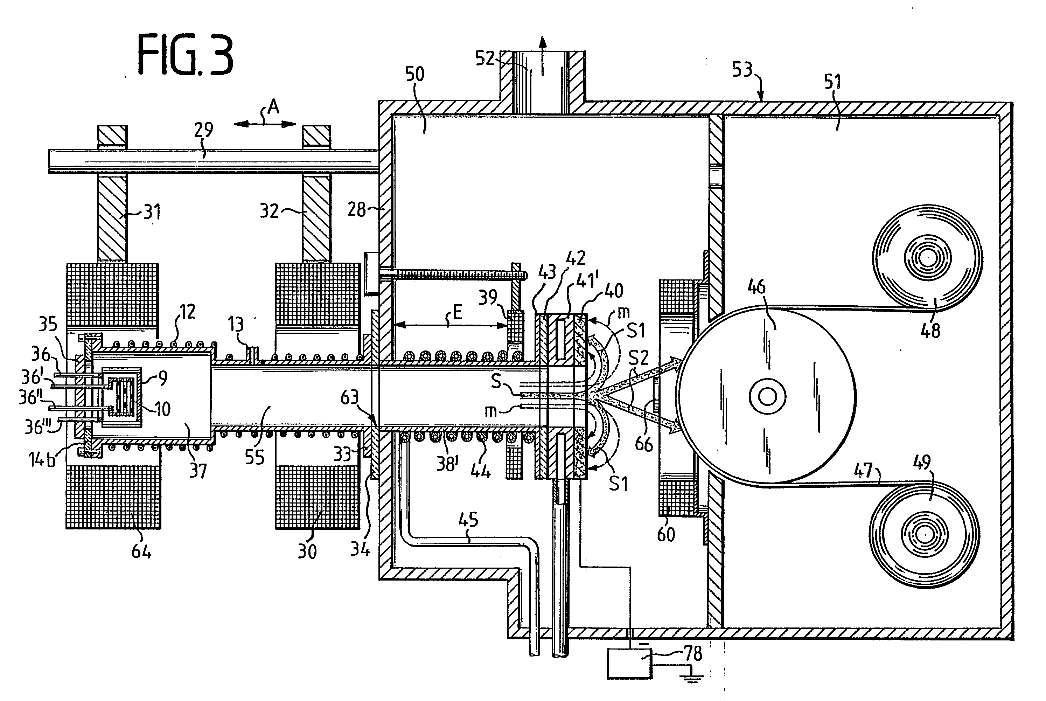

Die Vorrichtung gemäß Figur 3 weist eine im Querschnitt rechteckige Anode 55 und einen entsprechend ausgeformten Rohrstutzen 38' auf, wobei der Rohrstutzen 38' von einem zusätzlichen rahmenförmigen Elektromagneten 39 umgeben ist, der in Pfeilrichtung E verschiebbar ist. Außerdem ist das in der an die Pumpöffnung 52 angeschlosenen mit der Kammer 51 verbundenen Kammer 50 des Vakuumkessels 53 angeordnete Target 40 zusammen mit dem Kühlflansch 41 an einem ring- oder rahmenförmigen Isolator 42 befestigt, der seinerseits an dem Flansch 43 fest angeordnet ist, der Teil des Rohrstutzens 38' ist. Der Rohrstutzen 38'

ist mit einer Rohrschlange 44 umwickelt, die gleichzeitig als Magnetspule wirkt und die an das Rohr 45 angeschlossen ist, das einerseits Kühlwasser zu- und abführt und andererseits den Stromleiter für den Elektromotoren 44 bildet. Dem Target 40 gegenüberliegend ist die Beschichtungswalze 46 vorgesehen, über die das Substrat bzw. die Substratfolie 47 vom Abwickler 48 zum Aufwickler 49 läuft.

Das während des Betriebs aus dem Rohrstutzen 38' austretende Plasma wird insbesondere von dem Magneten 39 auf das Target 40 gezogen, wobei in der Plasma-Randschicht die Gas-Ionen durch das elektrische Feld beschleunigt werden und auf das Target 40 aufschlagen und dessen Oberfläche zerstäuben. Dabei bildet sich am Target 40 kein Erosionsgraben aus; vielmehr wird das Material des Targets 40 vergleichsweise gleichmäßig abgetragen. Eine Platte 66 zwischen Target 40 und Substrat 47 verhindet, daß der mittlere Faden des Plasmastrahls S direkt auf das Substrat 47 auftrifft. Schließlich ist an dem die beiden Kammern 50, 51 voneinander trennenden Wandteil noch eine ring- oder rahmenförmige Magnetspule 60 befestigt, über die die Plasma-Fäden S2 gesteuert bzw. beeinflußt werden können.

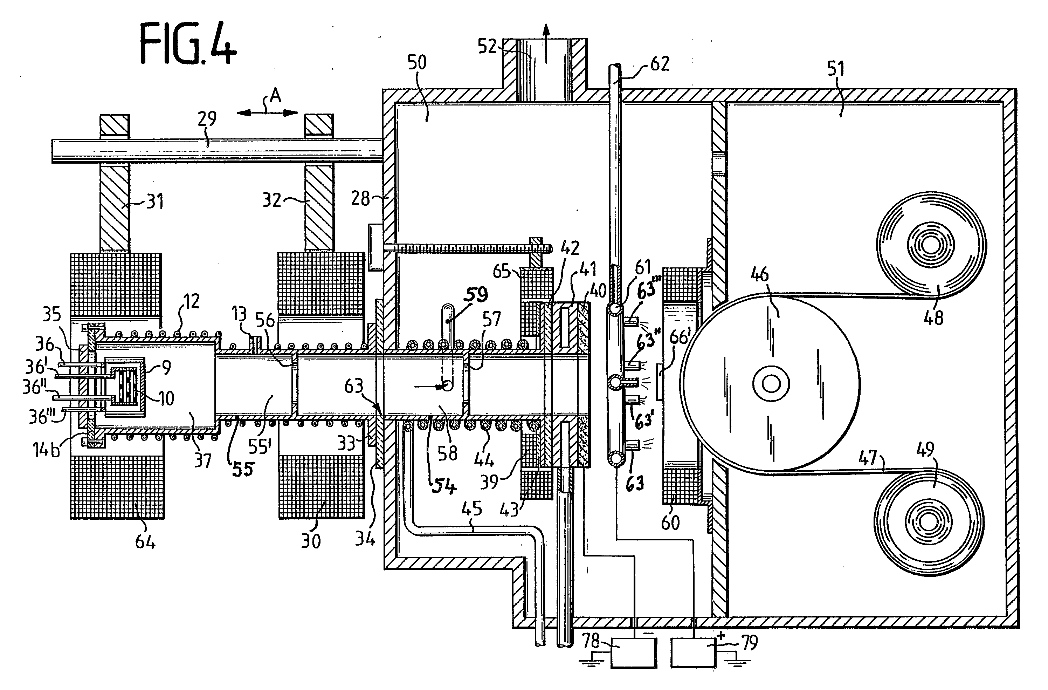

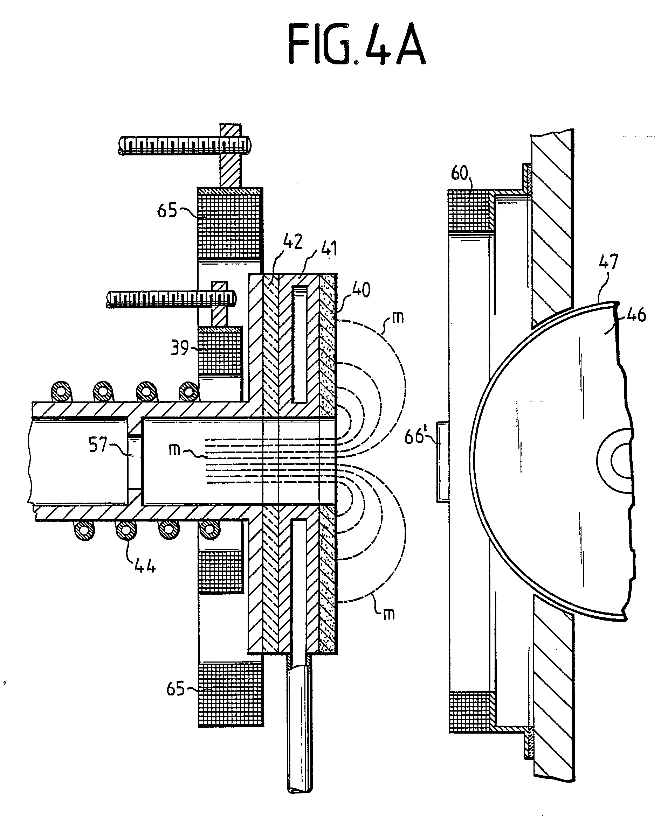

Bei der Vorrichtung gemäß Figur 4 sind der Rohrstutzen 54 und die Anode 55 mit Blenden 56, 57 versehen, wobei die von den beiden Blenden 56, 57 begrenzte Kammer 58 an ein zusätzliches Absaugrohr 59 angeschlossen ist. Diese Zwischen-Absaugung gestattet es, einen möglichen Neutral-Teilchenfluß vom Substrat 40 zur Quelle 9 zu verringern oder ganz zu vermeiden. Zwischen der Beschichtungwalze 46 und dem Target 40 ist neben der Magnetspule 60 ein an die Rohrleitung 62 angeschlossenes rahmenförmiges Gaseinlaßrohr 61 mit Düsen 63, 63', ... angeordnet. Außerdem ist noch eine weitere, verschiebbare Magnetspule 65 vorgesehen, die in Verbindung mit den anderen Magnetspulen 44, 60 eine Beeinflussung der Plasmawolke im Bereich des Targets 40 gestattet. Das aus den Düsen 63, 63' ausströmende Gas (z.B. Sauerstoff) ermöglicht es, das Plasma reaktionsfreudiger zu machen. Eine im Bereich der Längsachse des Rohrstutzens 54 angeordnete Platte 66' erlaubt es, den zentralen Plasmafaden abzuschirmen.

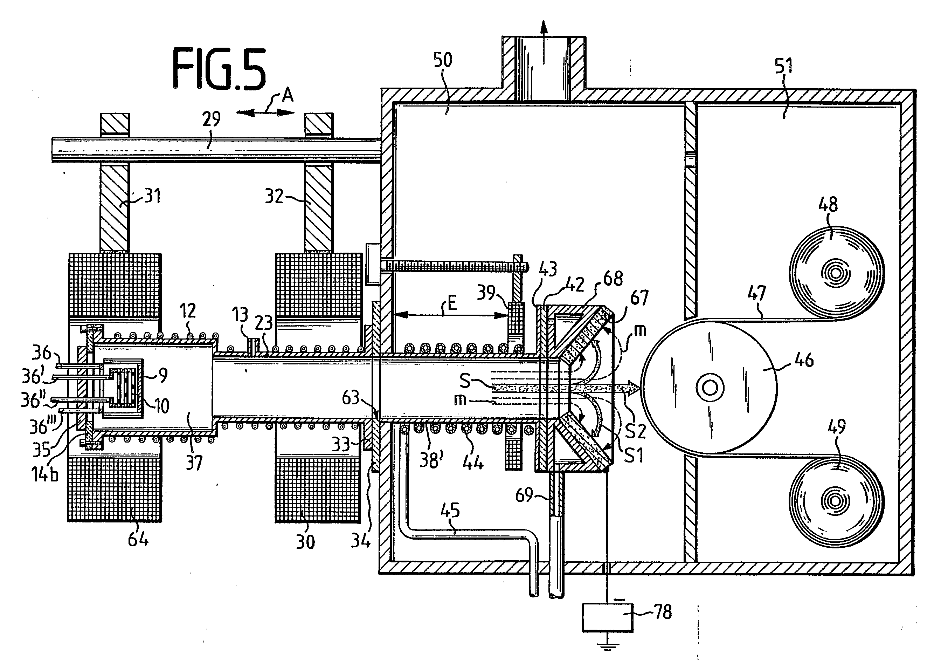

Bei der Ausführungsform gemäß Figur 5 ist das Target 67 gegenüber demjenigen nach Figur 3 wannen- oder trichterförmig ausgebildet, wobei auch der an die Kühlleitung 69 angeschlossene Kühlflansch 68, der am Isolatorring 42 befestigt ist, eine entsprechende Wannen- oder Trichterform aufweist. Durch die Schrägstellung der Oberfläche des Targets 67 zur Längsachse des Rohrstutzens 38' wird eine Komponente des elektrischen Feldes genutzt, die senkrecht zum Magnetfeld verläuft, so daß am Target 67 eine magnetrongemäße Rennbahn entsteht.

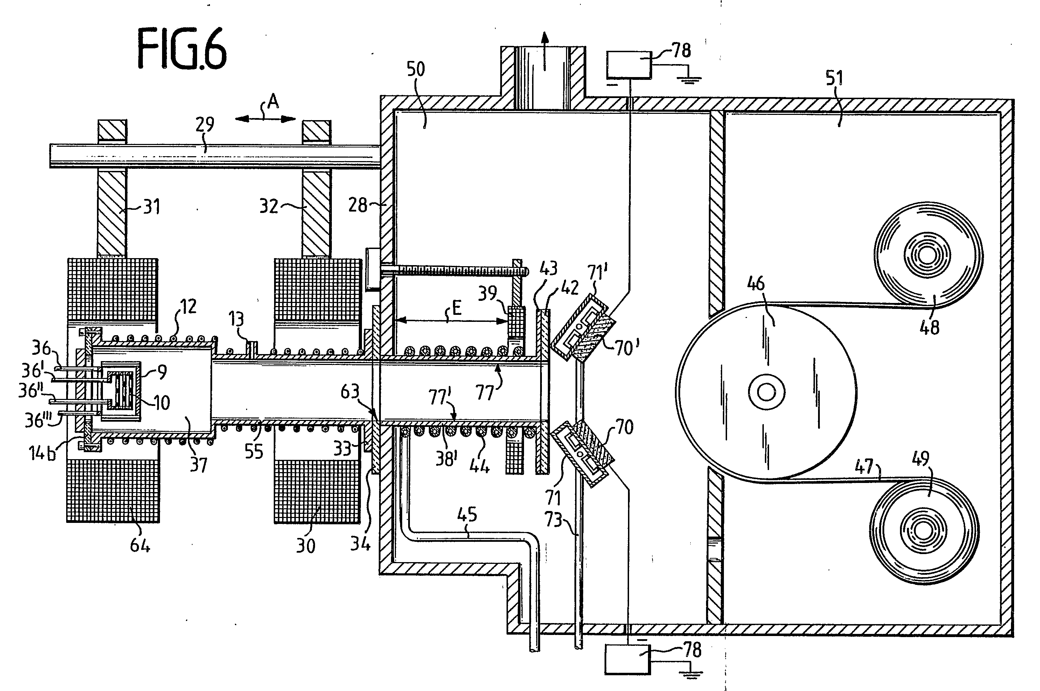

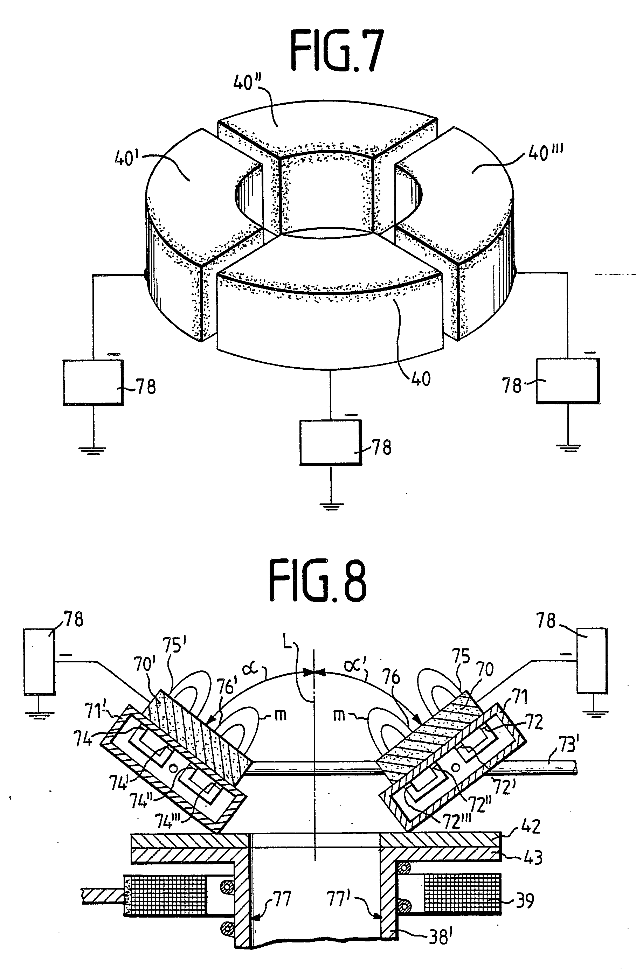

Bei der Ausführungsform nach Figur 6 sind zwei platten- oder quaderförmige Targets 70, 70' auf zwei an die Kühlleitung 73 angeschlossenen Kühlflanschen 71, 71 befestigt, die in ihrem Innern Permanentmagnete 72, 72', 72", ... bzw. 74, 74',... aufweisen (siehe auch Figur 8), deren Magnetfelder mehrere Rennbahnen 75, 76 bzw. 75', 76' erzeugen können. Die beiden Targets 70, 70' bilden jeweils mit der Längsachse des Rohrstutzens mit rechteckigem Profil die Winkel α und α' von jeweils etwa 45°.

Wie Figur 7 zeigt, kann das Target 40 gemäß den Figuren 3 und 4 auch aus mehreren kreissektorförmigen Teilen 40', 40", 40'''... zusammengesetzt sein, wobei die einzelnen Teile 40', 40", ... aus verschiedenen Werkstoffen gebildet und einzeln an eine Stromquelle 78 angeschlossen sein können.

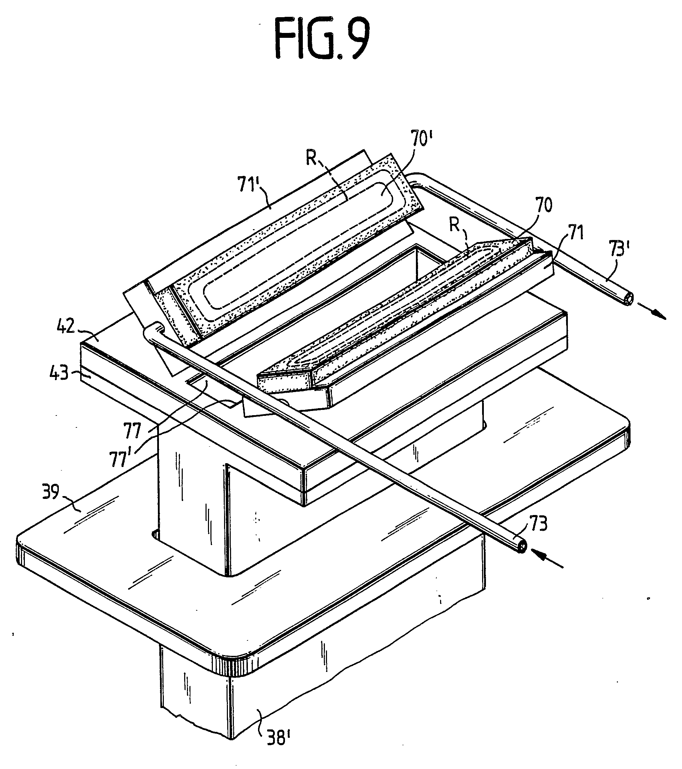

Die in den Figuren 8 und 9 in verschiedenen Ansichten dargestellten Targets 70, 70' gestatten eine vollständig gleichmäßige Beschichtung eines bandförmigen Substrats 47 von vergleichsweise großer Breite, wobei die Figur 9 deutlich macht, daß der Rohrstutzen 38', ein rechteckiges Profil aufweist und daß die beiden ebenen Targetflächen geneigt zu den einander gegenüberliegenden Innenwänden 77, 77' des Rohrstutzens 38' angeordnet sind.

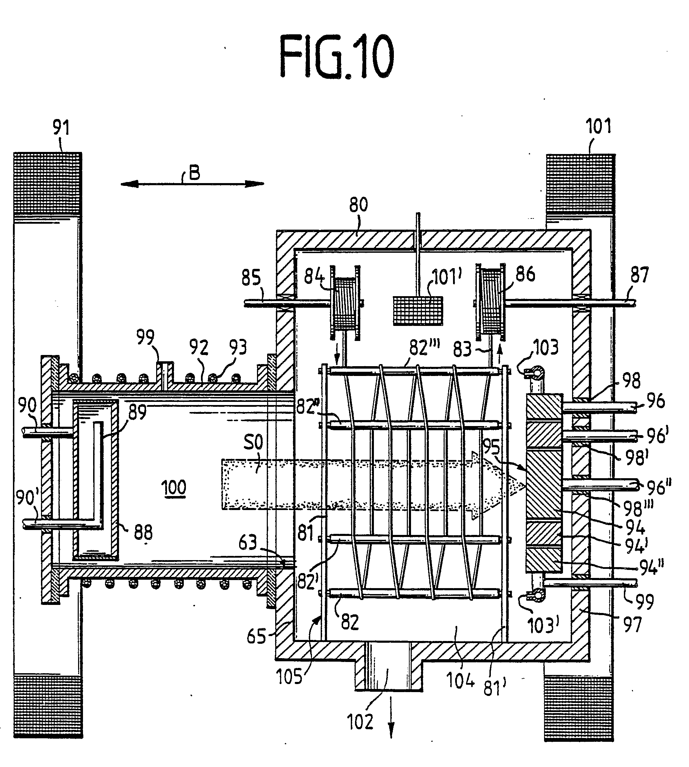

Die Vorrichtung gemäß Figur 10 unterscheidet sich von denjenigen nach den Figuren 1 bis 9 im wesentlichen dadurch, daß im Vakuumkessel 80 an Stelle eines über Wickler 3, 4 bzw. eine Beschichtungswalze 5 geführten bandförmigen Substrats 15 ein als Draht ausgebildetes Substrat 83 über ein käfigartiges Gestell 105, auf dem sechs zueinander parallele Rollen 82, 82', ... drehbar gelagert sind, geführt ist. Der Draht 83 läuft während des Beschichtungvorganges von einem auf einer Welle 85 gelagerten Abwickler 84 über die Rollen 82, 82', ... auf den auf einer angetriebenen Welle 87 angeordneten Aufwickler 86. Der Elektronen-Emitter 88 mit Heizung 89 und den Wasser- und Stromdurchführungen 90, 90' ist prinzipiell so aufgebaut wie der in Figur 1 dargestellte, wobei jedoch lediglich eine in Richtung B verschiebbare Magnetspule 91 die rohrförmige Anode 92 mit ihrer Rohrschlange 93 umgreift. Das Target 95 ist aus mehreren konzentrisch zueinander angeordneten Teilen, 94, 94', 94" gebildet und so angeordnet, daß seine kreisscheibenförmige Stirnfläche quer zur Längsachse der rohrförmigen Anode 92 steht.

Im übrigen ist das Target 95 mit Wasser- und Stromanschlüssen 96, 96', 96" versehen, die bei 98, 98', 98" durch die Stirnwand 97 hindurchgeführt sind. Mit 99 ist ein Rohrstutzen für den Einlaß des Gases über die Düsen 103, 103' in die Quelle bezeichnet und mit 101 eine Magnetspule, die den Vakuumkessel 80 umschließt. Beide Magnetspulen 91, 101 sind parallel der Längsachse der rohrförmigen Anode 92 in Pfeilrichtung B verschiebbar. Die nicht näher dargestellte Vakuumpumpe ist an die Pumpemöffnung 102 der Kammer 104 des Vakuumkessels 80 angeschlossen.

Es sei noch erwähnt, daß die rohrförmige Anode 92 auch einen Rohrstutzen für den Einlaß des Prozeßgases in die Generatorkammer 100 aufweist. Die Rollen 82, 82', ... sind auf den ringförmigen Rollenhaltern 81, 81' gelagert, die den zentralen Durchtritt des Plasmastroms SO zum Target 95 gestatten. Über den Magneten 101 ist der Plasmastrahl im Bereich des Käfigs 105 unmittelbar beeinflußbar.

Die vorliegende Erfindung schafft eine Vorrichtung zum Hoch-Raten Sputtern und/oder Verdampfen von metallischen oder dielektrischen Werkstofen mit Hilfe eines außerhalb der eigentlichen Vakuumkammer erzeugten Plasmastroms beliebigen Querschnitts. Die Energie, die auf das Target einwirkt ist dabei erheblich größer als bei herkömmlichen Vorrichtungen wie beispielsweise Magnetron- oder Dioden-Anordnungen. Der Aufbau der erfindungsgemäßen Vorrichtungen ist vergleichbar einfach und das Plasma wird vollkommen unabhängig vom Target erzeugt.

Die Target-Spannung und der Target-Strom können unabhängig voneinander eingestellt werden, was bei bekannten Vorrichtungen ebenfalls nicht möglich ist.

Im Vergleich zum Gegenstand nach der vorstehend beschriebenen Erfindung benötigen herkömmliche Magnetron-Beschichtungsvorrichtungen Drücke im Bereich von 3 -10 millitorr; Bei solchen Drücken beträgt die freie Weglänge eines abgestäubten Atoms bestenfalls einen Zentimeter. Wegen dieser kurzen freien Weglänge haben sich die abgsputterten Werkstoffteilchen zerstreut bevor sie das Substrat erreicht haben. Üblicherweise ist eine Energie von 400 - 600 eV aufzubringen um brauchbare Magnetron-Sputter-Raten zu erzielen; bei diesem Energie-Level sind in der Regel sowohl die Targets als auch die Substrate rasch beschädigt bzw. verformt oder aber es haben unerwünschte chemische Reaktionen an der Oberfläche des Targets stattgefunden. (Ein Beispiel hierfür liefert die US-Ps 4.588.490). Magnetron-Systeme sind außerdem Werkstoff-spezifisch, was bedeutet, daß die Ausbeute an Sekundärelektronenan der Target-Oberfläche die Wirksamkeit des Plasmas bestimmen. Weiterhin ist der Effekt der magnetischen Drift (ExB) beim Sputtern bei dem elektrische Kraftfelder die magnetischen Feldlinien kreuzen, ein allgemein bekanntes Phänomen ( wie aus der US-Ps 2.146.025 und der US-PS 4.166.018 entnehmbar ist).

Im Falle, daß mit einer der beschriebenen Anlagen eine Plasma-CVD durchgeführt werden soll (beispielsweise mit der in Figur 2 dargestellten Vorrichtung) korrespondiert die Vakuumkammer 17 ebenfalls mit einer Einrichtung zur Erzeugung eines Plasmastrahls S, die einen Elektronenemitter 9 mit einer nachgeschalteten rohrförmigen Anode 11 aufweist, die einen Einlaß 13 für das Prozeßgas zum Zünden des Plasmastrahls S besitzt, wobei die Anode 11 mit einem Rohrstutzen 19 zusammenwirkt, der sowohl in die Anode 11, als auch in die Vakuumkammer 17 einmündet. Außerdem werden die Magnete 12, 21, 30, 64, 106 zum Ausrichten und Führen des Plasmastrahls S durch die Anode 11 in die Vakuumkammer 17 benötigt, wobei in der Vakuumkammer der Substrathalter mit dem von diesem gehaltenenen und/oder geführten Substrat (beispielsweise die von dem Abwickler 3 über eine Beschichtungswalze 5 zu einem Aufwickler 4 geführte Substratfolie 15) angeordnet ist. In den aus dem Rohrstutzen 19 austretenden Plasmastrahl S mündet dabei ein Rohr 38 für den Einlaß einer die Plasmapolymerisation bewirkenden Substanz, beispielsweise $SiH_4$ (Silan), ein. In diesem Falle ist das Target 7 überflüssig, d. h. es kann entweder ausgebaut werden oder aber es wird während des Betriebs die Spannung für das Target 7 abgeschaltet. Für den Fall, daß das Target 7 aus der Kammer 17 entfernt wird, ist es zweckmäßig an der Innenseite der Gehäusewand 27 eine elektrisch isolierte Prallplatte im Bereich des Pfeiles D anzubringen um eine unerwünschte Beschichtung der Gehäusewand 27 vermeiden. Es ist klar, daß der Plasmastrahl möglichst direkt auf das Substrat oder zumindest in dessen unmittelbare Nähe gerichtet werden muß. Die in den Plasmastrahl S eingelassene Substanz kann sowohl gasförmig, als auch flüssig oder pulverförmig sein. Diese Substanz wird physikalisch oder chemisch verändert und auf dem Substrat 15 niedergeschlagen.

## Auflistung der Einzelteile

1 Vakuumkessel, Vakuumkammer
2 Pumpöffnung
3 Abwickler
4 Aufwickler
5 Beschichtungswalze, Substrathalter
6 Magnetspule
7 Target
8, 8', 8" Wasser- und Stromdurchführungen
9 Elektronen-Emitter
10 Heizung
11 Anode
12 Rohrschlange

13 Einlaßstutzen
14 Isolator
14a, 14b Isolator
15 Substratfolie, Substratdraht, Substrat
16 Kammer, Vakuumkammer
17 Kammer, Vakuumkammer
18 Trennwand
19 Rohrstutzen
20 Rohrstück
21, 21' Magnetspule
22 Rohr
23 Anode
24 Lagerbock
25 Schlauchleitung
26 Schlauchleitung
27 Stirnwand
28 Stirnwand
29 Schiene
30 Magnetspule
31 Spulenhalterung
32 Spulenhalterung
33 Flansch
34 Isolator
35 Lochplatte
36, 36', ... Wasser- und Stromdurchführungen ·
37 Generatorkammer
38, 38' Rohrstutzen
39 Elektromagnet
40, 40', 40" Target
41 Kühlflansch
42 Isolatorring, Isolatorrahmen
43 Flansch
44 Rohrschlange
45 Rohr
46 Beschichtungswalze, Substrathalter
47 Substrat, Substratfolie
48 Abwickler
49 Aufwickler
50 Kammer, Vakuumkammer
51 Kammer, Vakuumkammer
52 Pumpöffnung
53 Vakuumkessel
54 Rohrstutzen
55, 55' Anode, Anodenkammer
56 Blende
57 Blende
58 Kammer
59 Absaugrohr
60 Magnetspule
61 Gaseinlaßrohr
62 Rohrleitung
63, 63', ... Düse
64 Magnetspule
65 Magnetspule
66, 66' Platte
67 Target

68 Kühlflansch
69 Kühlleitung
70, 70' Target
71, 71' Kühlflansch
72, 72', ... Permanentmagnet
73 Kühlleitung
74, 74', ... Permanentmagnet
75, 75' Feldlinie
76, 76' Feldlinie
77, 77' Innenwand des Rohrstutzens
78 Stromquelle
79 Stromquelle
80 Vakuumkessel
81, 81' Rollenhalter
82, 82', ... Rolle
83 Substrat, Draht
84 Abwickler
85 Welle
86 Aufwickler
87 angetriebene Welle
88 Elektronen-Emitter
89 Heizung
90, 90' Wasser-/Stromdurchführung
91 Magnetspule
92 Anode
93 Magnetspule, Rohrschlange
94, 94', 94" Teile des Targets
95 Target
96, 96', 96" Wasser-/Stromanschluß
97 Stirnwand
98, 98', 98" Durchführung
99 Rohrstutzen
100 Generatorkammer
101 Magnetspule
102 Pumpöffnung
103, 103' Gasauslaßdüse
104 Vakuumkammer
105 Substrathalter
106 Magnet
S1    Plasmastrahl der das Target 7 bzw. 40, 67 trifft (Fig. 1, 2, 2A, 2B, 3, 5)
m    Magnetfeld-Linien zwischen den Magnetspulen 21, 21' der Rohrstücke 19, 20 (Fig. 1) bzw. zwischen der Magnetspule 21 und dem Magneten 6 (Fig. 2, 2A, 2B) bzw. zwischen der Magnetspule 44 und dem Magneten 39 bzw. 65 des Targets 40 (Fig. 3, 3A), bzw. der Magnetspule 44 und dem Magneten 39 des Targets 67 (Fig. 5), bzw. den Magneten 74, 74', 74", 74''' und 72, 72', 72", 72''' der Targets 70, 70' (Fig. 8)
S2    Plasmastrahl der vom Plasmastrahl S vor dem Target abzweigt und das Substrat 15, 47 trifft (Fig. 1, 2, 2A, 2B, 3, 5)
SO    geschlossener Plasmastrahl der durch den Käfig 105 hindurchgeführt ist und auf das mehrteilige Target 95 auftrifft (Fig. 10)

L    Längsachse des ungeteilten Plasmastrahls S
R    Rennbahn der Targets 70 bzw. 70´

**Ansprüche**

1. Kathoden-Zerstäubungsvorrichtung, dadurch gekennzeichnet, daß die Vakuumkammer (16, 17, 50, 51, 104 ) mit einer Einrichtung (9 - 13, 37) zur Erzeugung eines Plasmastrahls (S) verbunden ist und ein Target (7, 40, 67, 70, 70´, 94, 95) aufweist, das mit Magneten (21, 21´, 6, 39, 44, 65, 101) zusammenwirkt, die den Plasmastrahl (S) auf die Oberfläche des Targets (7, 40, 67, 70, 70´, 94, 95) lenken und mit einer Einrichtung versehen ist um Ionen im Plasmastrahl (S) zu beschleunigen, die die Oberfläche des Targets (7, 40, 67, 70, 70´, 94, 95) treffen und Teilchen herauslösen und Substrathalter (5, 46, 82, 82´, ...) aufweist, die im Inneren der Vakuumkammer (16, 17, 50, 51, 104) zur Halterung der Substrate (15, 47, 83) für die Beschichtung mit abgestäubten Teilchen angeordnet sind und vorzugsweise mit einer Einrichtung beispielsweise einer Magnetanordnung (60, 101, 106) ausgestattet ist, für die Ablenkung zumindest eines Fadens oder Teilstrahls (S2) des Plasmastrahls (S) vom Target auf das Substrat (15, 47, 83).

2. Vorrichtung nach Anspruch 1, dadurch gekennzeichnet, daß der Plasmastrahl-Generator (9 - 13, 37) einen Elektronen-Emitter (9) mit einer nachgeschalteten rohrförmigen Anode (11, 23, 55, 55´) aufweist die einen Einlaß (13) für das Prozeßgas zum Zünden des Plasmastrahls besitzt, wobei die Anode mit einem Rohrstutzen (19, 38, 38´, 54) korrespondiert, der sowohl mit der Anode (11, 55) als auch mit der Vakuumkammer (16, 17, 50, 51) zusammenwirkt und Magnete (21, 21´, 44, 93) zum Ausrichten und Führen des Plasmastrahls (S) durch die Anode (11, 55) in die Prozeßkammer aufweist.

3. Vorrichtung nach Anspruch 2, dadurch gekennzeichnet, daß die Form des plattenartigen Elektronen-Emitters (9) dem Querschnitt des Plasmastrahls (S) entspricht.

4. Vorrichtung nach Anspruch 3, dadurch gekennzeichnet, daß die Form des plattenartigen Elektronen-Emitters (9) kreisscheibenförmig ist.

5. Vorrichtung nach Anspruch 3, dadurch gekennzeichnet, daß die Form des Elektronen-Emitters (9) rechteckig ist.

6. Vorrichtung nach Anspruch 1, dadurch gekennzeichnet, daß das Target (7, 40, 67, 70, 70´) sich außerhalb des zentralen Pfads des Plasmastrahls (S2) befindet.

7. Vorrichtung nach Anspruch 6, dadurch gekennzeichnet, daß das Target (40, 67) den Plasmastrahl (S) umschließt und dem Substrat (46) zum Zwecke der Beschichtung gegenüberliegt.

8. Vorrichtung nach Anspruch 1, gekennzeichnet durch Stutzen (38´, 61, 62, 99, 103, 103´) zum Einleiten einer reaktiven Substanz in die Umgebung der Oberfläche des Targets (7, 40, 94, 94´, 94˝).

9. Vorrichtung nach Anspruch 1, dadurch gekennzeichnet, daß die Einrichtung zur Ablenkung eines Fadens (S2) des Plasmastrahls (S) Magnete (60, 101, 106) umfaßt, die in unmittelbarer Nachbarschaft der Substrathalter angeordnet sind.

10. Vorrichtung nach Anspruch 1, dadurch gekennzeichnet, daß der Magnet (6, 21´, 39, 65) zum Führen des Plasmastrahls (S1) auf der Rückseite des Targets (7, 40, 67, 70, 70´) angeordnet ist.

11. Vorrichtung nach Anspruch 1, dadurch gekennzeichnet, daß das Target (7) auf dem Targethalter (24) relativ zum Plasmastrahl (S1) verschiebbar angeordnet ist.

12. Vorrichtung nach Anspruch 2, dadurch gekennzeichnet, daß der Rohrstutzen (19, 38, 38´, 54) etwa vieleckig im Querschnitt ausgebildet ist.

13. Vorrichtung nach Anspruch 2, dadurch gekennzeichnet, daß der Rohrstutzen (19, 38, 38´, 54) etwa rechteckig im Querschnitt ausgebildet ist.

14. Vorrichtung nach Anspruch 2, dadurch gekennzeichnet, daß der Rohrstutzen (19, 38, 38´, 54) einen etwa ovalen Querschnitt aufweist.

15. Vorrichtung nach Anspruch 2, dadurch gekennzeichnet, daß der Rohrstutzen (19, 38, 38´, 54) einen etwa kreisrunden Querschnitt aufweist.

16. Vorrichtung nach Anspruch 1, gekennzeichnet durch eine Kühleinrichtung (41, 68, 69, 71, 71´, 73, 73´) zum Kühlen des Targets (7, 40, 67, 70, 70´).

17. Vorrichtung nach Anspruch 2, dadurch gekennzeichnet, daß die Anode (55´) und der Rohrstutzen (54) mit Hilfe von zwei Blenden (56, 57) in Kammern (37, 58) aufgeteilt ist, die über ein Absaugrohr (59) an eine Vakuumquelle angeschlossen sind.

18. Vorrichtung nach Anspruch 7, dadurch gekennzeichnet, daß das Target (67) etwa schüsseloder trogförmig ausgebildet ist.

19. Vorrichtung nach Anspruch 7, dadurch gekennzeichnet, daß zwei Hälften des Targets (70, 70´) winklig zueinander angeordnet sind.

20. Vorrichtung nach Anspruch 7, dadurch gekennzeichnet, daß das Target (67) etwa trichterförmig ausgebildet ist.

21. Vorrichtung nach Anspruch 1, dadurch gekennzeichnet, daß das Target (40, 40´, 40˝, 40‴ bzw. 94, 94´, 94˝) aus mehreren einzelnen Teilen gebildet ist, die aus verschiedenen Werkstoffen bestehen.

22. Vorrichtung nach Anspruch 21, dadurch gekennzeichnet, daß die einzelnen Teile des Targets (40, 40', 40", 40"') konzentrisch und um die Längsachse des Plasmastrahls (S) herum angeordnet sind wobei jedes dieser Teile unabhängig vom benachbarten Teil Ionen im Plasmastrahl beschleunigt.

23. Vorrichtung nach Anspruch 21, dadurch gekennzeichnet, daß die einzelnen Teile des Targets (94, 94', 94") als nebeneinanderliegende Segmente in einer gemeinsamen Ebene angeordnet sind, wobei jedes einzelne Teil unabhängig vom benachbarten Teil Ionen im Plasmastrahl beschleunigt.

24. Vorrichtung nach Anspruch 7, dadurch gekennzeichnet, daß das Target ( 70, 70') Magnete (72, 72', 72", 72"' bzw. 74, 74', 74", 74"') aufweist, die geschlossene magnetische Tunnels (m) an den Oberflächen der Targets (70, 70') erzeugen.

25. Vorrichtung nach Anspruch 2, dadurch gekennzeichnet, daß Teile des Elektronen-Emitters (9, 88) aus Lanthanhexaborid gebildet sind.

26. Vorrichtung nach Anspruch 7, dadurch gekennzeichnet, daß die Targetanordnung aus einem Paar Targets (70, 70') gebildet ist.

27. Vorrichtung nach den Ansprüchen 19 und 26, dadurch gekennzeichnet, daß die einzelnen Targets (70, 70') des Target-Paares jeweils einen rechteckigen Querschnitt aufweisen, wobei jedes der Targets in einem Winkel (α, α') nicht größer als 90° zur Längsachse (L) des aufgeteilten Plasmastrahls (S) angeordnet ist.

28. Vorrichtung nach einem oder mehreren der vorhergehenden Ansprüche, dadurch gekennzeichnet, daß die Einrichtung zum Beschleunigen der Ionen von einer hochfrequenten Spannung oder aber mit Spannungsstößen oder mit einer einstellbaren Wechselspannung beaufschlagt sind.

29. Vorrichtung nach Anspruch 8, dadurch gekennzeichnet, daß die Vorrichtung Gaseinlaßöffnungen (38, 38', 61, 62, 103, 103') aufweist, wobei die reaktive Substanz ein Gas ist.

30. Vorrichtung nach Anspruch 29, dadurch gekennzeichnet, daß die Gaseinlaßöffnungen (61, 103, 103') konzentrisch zum Target (40, 94, 94', 94") oder kranzförmig um dieses herum angeordnet sind.

31. Vorrichtung nach Anspruch 29, dadurch gekennzeichnet, daß die Gaseinlaßöffnungen (38, 38') etwa parallel zur Ebene des Targets (7) angeordnet ist.

32. Vorrichtung nach einem oder mehreren der vorhergehenden Ansprüche, dadurch gekennzeichnet, daß die zu beschichtenden Substrate an eine einstellbare elektrische Spannungsquelle anschließbar sind.

33. Kathoden-Zerstäubungsvorrichtung, gekennzeichnet durch eine Plasmaquelle (88), durch ein Target (94, 94', 94") das dem Plasmastrahl (S0) in der Vakuumkammer (104) ausgesetzt ist, durch einen Magneten (101) der den Plasmastrahl (S0) auf die Oberfläche des Targets (94, 94', 94") lenkt, durch eine Spannungsquelle, die Ionen im Plasmastrahl (S0) auf die Oberfläche des Targets (94, 94', 94") beschleunigt und dort Teilchen zerstäubt und durch einen käfigartigen Substrathalter (105) an der Vorderseite des Targets, der den Plasmastrahl (S0) ringförmig umschließt und das Substrat (83) zum Zwecke der Beschichtung hält.

34. Vorrichtung nach Anspruch 33, dadurch gekennzeichnet, daß der Substrathalter (105) mehrere zueinander parallele Rollen (82, 82', 82", 82"') aufweist wobei ein strangförmiges Substrat (83), beispielsweise ein Draht um den käfigförmigen Substrathalter (105) herumlegbar ist.

35. Kathoden-Zerstäubungsvorrichtung, dadurch gekennzeichnet, daß an eine Vakuumkammer eine Einrichtung zur Erzeugung eines Plasmastrahls angeschlossen ist, wobei in der Vakuumkammer ein Gefäß angeordnet ist, daß einen zu verdampfenden Werkstoff enthält, wobei eine Magnetanordnung vorgesehen ist, der den Plasmastrahl auf den zu verdampfenden Werkstoff lenkt und wobei eine Einrichtung zum Beschleunigen von Ionen im Plasma-strahl auf den zu verdampfenden Werkstoff vorgesehen ist und wobei ein Substrathalter in der Vakuumkammer angeordnet ist, der ein Substrat zur Beschichtung mit dem verdampften Werkstoff hält.

36. Vorrichtung nach Anspruch 35, gekennzeichnet durch eine Einrichtung, beispielsweise eine Magnetanordnung um einen von einem Hauptstrahl abgezweigten Teil des Plasmastrahls auf das Substrat zu lenken.

37. Kathoden-Zerstäubungsvorrichtung, gekennzeichnet durch eine mit der Vakuumkammer verbundene Einrichtung zur Erzeugung eines Plasmastrahls und ein in der Vakuumkammer angeordnetes Target (7, 40, 67, 70, 70') mit einem Magneten (6, 39, 65), der den Plasmastrahl auf die Oberfläche des Targets (7, 40, 67, 70, 70') lenkt und mit einer Einrichtung zur Beschleunigung von Ionen im Plasmastrahl auf die Oberfläche des Targets (7, 40, 67, 70, 70') um auf dieser Teilchen abzustäuben und mit einem Substrathalter (24, 46), der in der Vakuumkammer angeordnet ist und ein Substrat (5, 47) hält, damit dieses mit abgestäubten Teilchen beschichtbar ist, wobei das Target (7, 40, 67, 70, 70') außerhalb des zentralen Pfads des Plasmastroms (S) angeordnet ist.

38. Vorrichtung nach Anspruch 37, dadurch gekennzeichnet, daß der Generator (37, 100) zur Erzeugung des Plasmastrahls (S) einen Elektronen-Emitter (9, 88), sowie eine rohrförmige Anode (11, 92) stromabwärts des Elektronen-Emitters (9, 88) aufweist und mit einer Einlaßöffnung (13, 99) zum Zuführen eines Prozeßgases und zur Zündung des Plasmastrahls versehen ist und eine Prozeßkammer bildet, die mit der Anode (11, 92), der Vakuumkammer (17, 50, 104) und mit Magneten (6, 39, 65) zum Lenken und Führen des Plasmastrahls durch die Anode (11, 92) und die Prozeßkammer zusammenwirkt.

39. Vorrichtung nach Anspruch 38, dadurch gekennzeichnet, daß die Form des Elektronen-Emitters (9) der Querschnittfläche des Plasmastrahls (S) entspricht.

40. Vorrichtung nach Anspruch 39, dadurch gekennzeichnet, daß der Elektronen-Emitter (9) einen kreisscheibenförmigen Querschnitt hat.

41. Vorrichtung nach Anspruch 39, dadurch gekennzeichnet, daß der Elektronen-Emitter (9) rechteckig ausgeformt ist.

42. Vorrichtung nach Anspruch 37, gekennzeichnet durch eine Prallplatte (66, 66') zur Abschirmung und Ablenkung eines mittleren Fadens des Plasmastrahls (S) vom Substrat (47).

43. Vorrichtung nach Anspruch 37, gekennzeichnet durch eine Rohrleitung (38, 38', 62) zum Einleiten einer reaktiven Substanz in die Umgebung der Oberfläche des Targets (7, 40).

44. Vorrichtung nach Anspruch 42, dadurch gekennzeichnet, daß die Einrichtung (66, 66') zum Ablenken eines Teils (S2) des Plasmastrahls (S) mit einem Magneten (60) zusammenwirkt, der dem Substrathalter (46) zugeordnet ist.

45. Vorrichtung nach Anspruch 37, dadurch gekennzeichnet, daß ein Magnet (6, 39, 65) zur Führung des Plasmastrahls hinter der Oberfläche des Targets (7, 40) angeordnet ist.

46. Vorrichtung nach Anspruch 37, dadurch gekennzeichnet, daß das Target (7) in seiner Lage relativ zum Plasmastrahl (S) verstellbar gehalten ist.

47. Vorrichtung nach Anspruch 38, dadurch gekennzeichnet, daß die Prozeßkammer (37, 55, 58, 100) einen etwa vieleckigen Querschnitt hat.

48. Vorrichtung nach Anspruch 38, dadurch gekennzeichnet, daß die Prozeßkammer einen etwa rechteckigen Querschnitt hat.

49. Vorrichtung nach Anspruch 38, dadurch gekennzeichnet, daß die Prozeßkammer einen etwa ovalen Querschnitt hat.

50. Vorrichtung nach Anspruch 38, dadurch gekennzeichnet, daß die Prozeßkammer einen etwa kreisrunden Querschnitt hat.

51. Vorrichtung nach Anspruch 37, dadurch gekennzeichnet, daß das Target (7, 40, 67, 70, 70') mit Kühlkanälen oder einem Kühlflansch (41, 41', 68, 71, 71') versehen ist.

52. Vorrichtung nach Anspruch 38, dadurch gekennzeichnet, daß die Anode (55) und der Rohrstutzen (54) Blenden (56, 57) aufweisen, die eine Kammer (58) begrenzen, die an eine Vakuumquelle (59) angeschlossen ist.

53. Vorrichtung nach Anspruch 37, dadurch gekennzeichnet, daß das Target aus mehreren einzelnen Teilen (40, 40', 40'', 40''') aus vorzugsweise zwei verschiedenen Werkstoffen gebildet ist.

54. Vorrichtung nach Anspruch 53, dadurch gekennzeichnet, daß die Teile (40, 40', 40'', 40''') des Targets ringförmig um die Längsachse des Plasmastrahls herum angeordnet sind, wobei jedes Teil (40, 40', 40'', 40''') an eine eigene Spannungsquelle (78) zur Beschleunigung der Ionen im Plasmastrahl angeschlossen ist.

55. Vorrichtung nach Anspruch 53, dadurch gekennzeichnet, daß die Teile (40, 40', 40'', 40''') des Targets in einer gemeinsamen Ebene nebeneinanderliegend, beispielsweise schachbrettartig, angeordnet sind, wobei jedes Teil an eine eigene Spannungsquelle (78) angeschlossen ist, um Ionen im Plasmastrahl zu beschleunigen.

56. Vorrichtung nach Anspruch 38, dadurch gekennzeichnet, daß der Elektronen-Emitter (9) aus Lanthanhexaborid gebildet ist.

57. Vorrichtung nach Anspruch 37, dadurch gekennzeichnet, daß die Einrichtung zum Beschleunigen der Ionen mit einer hochfrequenten Spannung, mit Spannungsstößen oder aber mit einer einstellbaren Wechselspannung beaufschlagt ist.

58. Vorrichtung nach Anspruch 43, dadurch gekennzeichnet, daß eine Zuführeinrichtung Gaseinlaßrohre (38, 62) umfaßt, wobei das Reaktivmittel ein Gas ist.

59. Vorrichtung nach Anspruch 58, dadurch gekennzeichnet, daß die Gaseinlaßöffnungen (61) konzentrisch zum Target (40) angeordnet sind.

60. Vorrichtung nach Anspruch 58, dadurch gekennzeichnet, daß die Gaseinlaßöffnungen (38) etwa parallel zur Oberfläche des Targets (7) angeordnet sind.

61. Vorrichtung nach Anspruch 37, gekennzeichnet durch Einrichtungen zur Versorgung des Substrats mit einer einstellbaren elektrischen Spannung zum Zwecke der Beschichtung.

62. Verfahren zur Kathoden-Zerstäubung, dadurch gekennzeichnet, daß eine Vakuumkammer (17, 50, 104) mit einem Plasmastrahl-Generator (9, 10, 11, 12, 13, bzw. 88, 89, 92, 93, 99) verbunden ist, der auf das Innere der Vakuumkammer (50, 104) einwirkt, daß ein Target (7, 40, 67, 70, 70', 95) und ein Substrathalter (5, 46, 105) in der Vakuumkammer (17, 50, 104) vorgesehen sind, wobei der Substrathalter das Substrat (15, 47, 83) zum Zwecke seiner Beschichtung hält, daß eine magnetische Einrichtung (39, 65, 101) den Plasmastrahl auf die Oberfläche des Targets (7, 40, 67, 70, 70', 95) lenkt, daß Ionen im Plasmastrahl beschleunigt werden, die die Oberfläche des Targets treffen und von dieser Teilchen abstäuben und daß ein Teil des Plasmastrahls abgeteilt und auf das Substrat gelenkt wird.

63. Verfahren nach Anspruch 62, dadurch gekennzeichnet, daß das Target (7, 40, 67, 70, 70') außerhalb des Pfads des Plasmastrahls angeordnet ist, wobei ein Teil (S2) des Plasmastrahls (S) abgelenkt und auf das Substrat (15, 47) gerichtet werden kann.

64. Verfahren nach Anspruch 62, dadurch gekennzeichnet, daß das Target (40, 67, 70, 70') den Plasmastrahl (S) symmetrisch umschließt und dem Substrat (47) zum Zwecke der Beschichtung gegenüberliegend angeordnet ist.

65. Verfahren nach Anspruch 62, dadurch gekennzeichnet, daß das Target (95) dem Plasmastrahl (SO) frontal gegenüberstehend angeordnet ist, wobei der Substrathalter (105) nach Art eines Käfigs ausgebildet und vor dem Target (95) angeordnet ist und den Plasmastrahl (SO) umschließt, wobei ein Teil des Plasmastrahls abgelenkt und auf das Substrat (83) gerichtet werden kann.

66. Verfahren nach Anspruch 62, dadurch gekennzeichnet, daß das Target aus mehreren einzelnen, aus verschiedenen gebildeten Teilen (40, 40', 40'', 40''' bzw. 94, 94', 94'') besteht, die sämtlich gleichmäßig abgestäubt werden.

67. Verfahren nach Anspruch 66, dadurch gekennzeichnet, daß die Teile des Targets ( 40, 40', 40'', 40''') konzentrisch zueinander angeordnet sind.

68. Verfahren nach Anspruch 66, dadurch gekennzeichnet, daß die Teile des Targets (40, 40', 40'', 40''' bzw. 94, 94', 94'') als in der selben Ebene und nebeneinanderliegende Segmente ausgebildet sind.

69. Verfahren nach Anspruch 62, dadurch gekennzeichnet, daß eine Prozeßphase für das Einführen einer reaktiven Substanz in die unmittelbare Nähe des Targets vorgesehen ist.

70. Verfahren nach Anspruch 69, dadurch gekennzeichnet, daß die reaktive Substanz ein Gas ist.

71. Verfahren nach Anspruch 70, dadurch gekennzeichnet, daß das Gas konzentrisch zum Target eingelassen wird.

72. Verfahren nach Anspruch 62, dadurch gekennzeichnet, daß der Plasmastrahl abgestäubte Teilchen ionisiert, wobei diese auf dem Substrats niedergeschlagen werden und wobei wahlweise ein Teil des Plasmastrahls abgelenkt und auf das Substrat gerichtet werden kann.

73. Verfahren nach Anspruch 72, dadurch gekennzeichnet, daß das Target aus einem Metall gebildet ist und Metallionen zum Zwecke der Beschichtung auf das Substrat gestäubt werden.

74. Verfahren nach Anspruch 62, dadurch gekennzeichnet, daß das Target von einem Werkstoff gebildet wird, der vom Plasmastrahl verdampft und dann auf das Substrat niedergeschlagen wird, wobei wahlweise ein Teil des Plasmastrahls abgelenkt und auf das Substrat gerichtet werden kann.

75. Kathoden-Zerstäubungsvorrichtung, gekennzeichnet durch, ein in einer Vakuumkammer (17, 50, 104) angeordnetes Substrat (15, 47, 83) und einem Elektronen-Emitter (9, 88), der einer separaten, mit der Vakuumkammer (17, 50, 104) korrespondierenden, die Anode (11, 23, 92) bildenden Generatorkammer (37, 100) zugeordnet ist und der nach dem Einleiten eines Prozeßgases in die Generatorkammer (37, 100) eine großflächige Plasmasäule (S) erzeugt, die unter der Einwirkung von Magneten (64, 30, 20, 21, 39, 65, 101) zwischen Elektronen-Emitter (9, 88) und einer Targetanordnung (7, 40, 67, 70, 70', 95) geführt ist, wobei die positiven Ionen durch Anlegen einer einstellbaren negativen Spannung auf das Target beschleunigt werden, von wo aus die abgestäubten Metallatome auf das Substrat (15, 47, 83) gelangen und wobei die Targetanordnung (7, 40, 67, 70, 70', 95) in unmittelbarer Nachbarschaft des dem Elektronen-Emitter (9, 88) gegenüberliegenden Ende des die Generatorkammer (37, 100) verlängernden Rohrstutzens (19, 38, 38' 54) oder Düse (63) angeordnet ist und mindestens einen Magneten (6, 39, 65, 101) aufweist, der auf der dem Substrat (15, 47, 83) abgewandten Seite der Targetanordnung angeordnet ist.

76. Vorrichtung nach Anspruch 75, dadurch gekennzeichnet, daß die Targetanordnung (7) auf einem ortsfesten Bock (24) gelagert ist und in ihrer Lage zum dem Elektronen-Emitter (9) abgewandten Ende des Rohrstutzens (19) sowohl schwenk- (Pfeilrichtung F), als auch längsverschiebbar (Pfeilrichtung D) gehalten ist.

77. Vorrichtung nach Anspruch 75, dadurch gekennzeichnet, daß das Target eine im wesentlichen rahmenförmige Konfiguration aufweist und am dem Elektronen-Emitter (9) abgewandten Ende des Rohrstutzens (38, 54) gehalten ist.

78. Vorrichtung nach Anspruch 75, dadurch gekennzeichnet, daß das dem Emitter abgekehrte Ende des Rohrstutzens (38, 54) einen Kragen oder Flansch (43) aufweist, an dem die Targetanordnung (40, 67, 70, 70') gehalten ist, wobei zwischen Targetanordnung (40, 67, 70, 70') und Flansch (43) mindestens ein Isolator (42) und mindestens ein vom Kühlmittel durchströmter Kühlflansch (41, 41', 68, 71, 71') angeordnet sind.

79. Vorrichtung nach einem der Ansprüche 75 bis 78, dadurch gekennzeichnet, daß der zwischen Target (67 und Isolator (42) angeordnete Kühlflansch (68) als rotationssymmetrischer, Kühlkammern aufweisender Torus mit vorzugsweise etwa trapezförmigem Querschnitt ausgebildet ist.

80. Vorrichtung nach einem oder mehreren der vorhergehenden Ansprüche, dadurch gekennzeichnet, daß die Targetanordnung (67) eine etwa wannen-, schalen- oder trichterförmige Konfiguration aufweist.

81. Vorrichtung nach einem oder mehreren der vorhergehenden Ansprüche, dadurch gekennzeichnet, daß die Kühlflansche (71, 71') einen oder mehrere Magnete (72, 72', ...; 74, 74', ...) aufweisen, die vom Kühlmittel umströmt sind und deren magnetische Felder sich unmittelbar an den den Targets (70, 70') aufbauen und dort die Ausbildung von Rennbahnen (bzw. Elektronenbahnen)(75, 75'; 76, 76') bewirken.

82. Vorrichtung nach einem oder mehreren der vorhergehenden Ansprüche, dadurch gekennzeichnet, daß an dem Emitter (9) abgekehrten Ende des Rohrstutzens (38') mehrere Targets (70, 70') angeordnet sind, die jeweils eine etwa parallelepipede Form aufweisen und die unter einem Winkel (   ,   ) zur Längsachse des Rohrstutzens (38') angeordnet sind, der jeweils einem rechten Winkel entspricht oder kleiner als ein rechter Winkel ist.

83. Kathoden-Zerstäubungsvorrichtung, dadurch gekennzeichnet, daß eine Vakuumkammer (17) mit einer Einrichtung zur Erzeugung eines Plasmastrahls (S) verbunden ist, die einen Elektronenemitter (9) mit einer nachgeschalteten rohrförmigen Anode (11) aufweist, die einen Einlaß (13) für das Prozeßgas zum Zünden des Plasmastrahls (S) besitzt, wobei die Anode (11) mit einem Rohrstutzen (19) korrespondiert, der sowohl in die Anode (11), als auch in die Vakuumkammer (17) einmündet und wobei Magnete (12, 21, 30, 64, 106) zum Ausrichten und Führen des Plasmastrahls (S) durch die Anode (11) in die Vakuumkammer (17) vorgesehen sind, die einen Substrathalter mit einem von diesem gehaltenen und/oder geführten Substrat, beispielsweise eine von einem Abwickler (3) über eine Beschichtungswalze (5) zu einem Aufwickler (4) geführte Substratfolie (15) aufweist und wobei in den aus dem Rohrstutzen (19) austretenden Plasmastrahl (S) ein Rohr (38) für den Einlaß einer eine Plasmapolymerisation bewirkenden Substanz, beispielsweise $SiH_4$ (Silan), einmündet.

FIG.1

# FIG.2

EP 0 308 680 A1

# FIG.2A

# FIG.2B

FIG.3

FIG.4

EP 0 308 680 A1

# FIG.4A

FIG.5

EP 0 308 680 A1

# FIG.6

EP 0 308 680 A1

# FIG.7

# FIG.8

# FIG.9

# FIG.10

| | **EINSCHLÄGIGE DOKUMENTE** | | EP 88113900.0 |
|---|---|---|---|
| **Kategorie** | Kennzeichnung des Dokuments mit Angabe, soweit erforderlich, der maßgeblichen Teile | Betrifft Anspruch | KLASSIFIKATION DER ANMELDUNG (Int. Cl.4) |
| A | US - A - 4 090 941 (R. J. WRIGHT) <br> * Ansprüche 1,2 * <br><br> -- | 1,2,8, 29 | C 23 C 14/34 |
| A | GB - A - 1 544 612 (G. A. KOVALSKY) <br> * Anspruch 1 * <br><br> -- | 1,37 | |
| A | AT - B - 378 971 (LEYBOLD-HERAEUS GMBH) <br> * Ansprüche 1,5 * <br><br> ---- | 1,2,8, 29 | |
| | | | **RECHERCHIERTE SACHGEBIETE (Int. Cl.4)** <br><br> C 23 C 14/00 <br> C 23 C 16/00 |

Der vorliegende Recherchenbericht wurde für alle Patentansprüche erstellt.

| Recherchenort | Abschlußdatum der Recherche | Prüfer |
|---|---|---|
| WIEN | 14-12-1988 | DUNGLER |